(19) Europäisches Patentamt
European Patent Office
Office européen des brevets

(11) **EP 2 897 065 A1**

(12) **EUROPEAN PATENT APPLICATION**

(43) Date of publication:
**22.07.2015 Bulletin 2015/30**

(51) Int Cl.:
*G06F 17/50* (2006.01)

(21) Application number: **14151741.7**

(22) Date of filing: **20.01.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Airbus Operations GmbH**
**21129 Hamburg (DE)**

(72) Inventor: **de Cornulier, Pierrick**
**22761 Hamburg (DE)**

(74) Representative: **Isarpatent**
**Patentanwälte Behnisch Barth Charles**
**Hassa Peckmann & Partner mbB**
**Friedrichstrasse 31**
**80801 München (DE)**

(54) **System and method for adjusting a structural assembly**

(57)     The present invention pertains to a method (M) for adjusting a structural assembly, the method (M) comprising: obtaining (M1) a kinematic model of the structural assembly, the kinematic model comprising a plurality of adjustable linkages of the structural assembly; obtaining (M2) a kinematic influence matrix, the kinematic influence matrix comprising information regarding the influence of each of the adjustable linkage positions of the plurality of adjustable linkages on the measurement value at each observation point of a plurality of predefined observation points; defining (M6) upper and/or lower thresholds for each of the measurement values at each observation point of the plurality of predefined observation points; and applying (M7) a linear least squares algorithm to determine a tuple of linkage positions to which the plurality of adjustable linkages are to be adjusted in order to get the measurement value at each observation point of a plurality of predefined observation points within the defined upper and/or lower thresholds.

FIG.1

**Description**

The present invention relates to a system and a method for adjusting a structural assembly, particularly structural assemblies of vehicles.

Aircraft have openings in the outer surface of the fuselage for functional reasons. For example, windows or doors are provided within cutouts of the fuselage of an aircraft. Especially doors and the corresponding door assembly are complex constructions having a lot of cinematic linkages, hinges and connectors. It takes highly experienced installation workers to find out which of the various adjustable parameters of the components of the door assembly should be modified to what extent in order to optimally fit the door assembly to the aircraft.

Document US 6,243,614 B1 discloses a method for optimizing assembly performance which optimizes the performance of a product having a plurality of characteristics such as measurements and tolerances.

Document CN 103 061 641 A discloses a method for eliminating mounting out-of-tolerance of front cabin doors of airplanes.

Document DE 195 30 725 A1 discloses a method for automatically mounting a door assembly in a vehicle.

One object of the invention is to provide solutions to facilitate and optimize the installation of a complex structural assembly in a vehicle or structure.

This object is achieved by a method having the features of claim 1 and a system having the features of claim 8.

A first aspect of the invention thus pertains to a method for adjusting a structural assembly, the method comprising: obtaining a kinematic model of the structural assembly, the kinematic model comprising a plurality of adjustable linkages of the structural assembly; obtaining a kinematic influence matrix, the kinematic influence matrix comprising information regarding the influence of each of the adjustable linkage positions of the plurality of adjustable linkages on the measurement value at each observation point of a plurality of predefined observation points; defining upper and/or lower thresholds for each of the measurement values at each observation point of the plurality of predefined observation points; and applying a linear least squares algorithm to determine a tuple of linkage positions to which the plurality of adjustable linkages are to be adjusted in order to keep the measurement value at each observation point of a plurality of predefined observation points within the defined upper and/or lower thresholds.

According to a second aspect of the invention, a system for adjusting a structural assembly comprises a model provision unit configured to provide a kinematic model of the structural assembly, the kinematic model comprising a plurality of adjustable linkages of the structural assembly, a matrix provision unit configured to provide a kinematic influence matrix, the kinematic influence matrix comprising information regarding the influence of each of the adjustable linkage positions of the plurality of adjustable linkages on the measurement value at each observation point of a plurality of predefined observation points, and a calculation unit configured to define upper and/or lower thresholds for each of the measurement values at each observation point of the plurality of predefined observation points, and to apply a linear least squares algorithm to determine a tuple of linkage positions to which the plurality of adjustable linkages are to be adjusted in order to keep the measurement value at each observation point of a plurality of predefined observation points within the defined upper and/or lower thresholds.

According to a third aspect of the invention, a non-transitory computer-readable medium comprises computer-readable instructions which, when executed on a computer, cause the computer to execute a method according to the first aspect of the invention.

The idea on which the present invention is based is to use a matrix of influence and the measurements of all positioning parameters associated with the structural assembly and to determine an optimum rigging solution for the various positioning parameters.

According to an embodiment of the method, the plurality of linkages of the structural assembly may further comprise a plurality of non-adjustable linkages, and the kinematic influence matrix may comprise information regarding the influence of each of the non-adjustable linkage positions of the plurality of non-adjustable linkages on the measurement value at each observation point of the plurality of predefined observation points, wherein the method may further comprise measuring the values at each observation point of the plurality of predefined observation points, and determining the actual position of each of the plurality of non-adjustable linkages on the basis of the kinematic influence matrix and the measured values at each observation point.

According to a further embodiment of the method, the method may further comprise determining the actual position of each of the adjustable linkage positions of the plurality of adjustable linkages.

According to a further embodiment of the method, determining the actual position of each of the adjustable linkage positions may further comprise measuring the actual position of each of the adjustable linkage positions.

According to a further embodiment of the method, a tuple of linkage positions may be determined taking into account the maximum allowed range of linkage positions for each of the plurality of adjustable linkages.

According to a further embodiment of the method, applying the linear least squares algorithm may include weighting at least one of the measurement values with a predefined weighting coefficient.

According to a further embodiment of the method, applying the linear least squares algorithm may comprise keeping at least one of the adjustable linkage positions constant during the execution of the algorithm.

According to an embodiment of the system, the plurality of linkages of the structural assembly may further comprise a plurality of non-adjustable linkages, and the kinematic influence matrix may comprise information regarding the influence of each of the non-adjustable linkage positions of the plurality of non-adjustable linkages on the measurement value at each observation point of the plurality of predefined observation points, wherein the calculation unit may be further configured to determine the actual position of each of the plurality of non-adjustable linkages on the basis of the kinematic influence matrix and measured values at each observation point of the plurality of predefined observation points.

According to a further embodiment of the system, the calculation unit may be further configured to determine the actual position of each of the adjustable linkage positions of the plurality of adjustable linkages.

According to a further embodiment of the system, the calculation unit may be further configured to determine the actual position of each of the adjustable linkage positions by measuring the actual position of each of the adjustable linkage positions.

According to a further embodiment of the system, the calculation unit may be further configured to determine a tuple of linkage positions taking into account the maximum allowed range of linkage positions for each of the plurality of adjustable linkages.

According to a further embodiment of the system, the calculation unit may be further configured to apply the linear least squares algorithm by weighting at least one of the measurement values with a predefined weighting coefficient.

According to a further embodiment of the system, the calculation unit may be further configured to keep at least one of the adjustable linkage positions constant during the execution of the linear least-squares algorithm.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.

Fig. 1   schematically illustrates a method for adjusting a structural assembly according to an embodiment of the invention in a first operational state.

Fig. 2   schematically illustrates a system for adjusting a structural assembly according to another embodiment of the invention.

In the figures, like reference numerals denote like or functionally like components, unless indicated otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

Structural assemblies within the meaning of this application may pertain to passenger door assemblies, cargo door assemblies, bulk door assemblies, nose door assemblies, main landing gear door assemblies, cabin monuments, flaps, slats or any similar assemblies within an aircraft which comprise a complex arrangement of components. Structural assemblies may further comprise car door assemblies, van door assemblies, truck door assemblies, train door assemblies or any similar assemblies comprising a complex arrangement of components. In particular, the methods and systems described hereinforth may pertain to the adjustment of any of the examples for structural assemblies as given above.

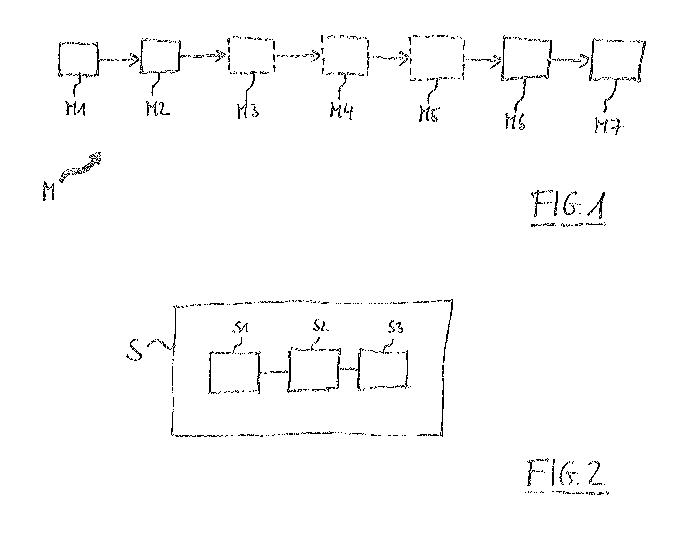

Fig. 1 schematically illustrates a method M for adjusting a structural assembly, in particular a door assembly. The method M may particularly be employed for adjusting a door assembly in an airborne vehicle.

The method M comprises as a first step M1 obtaining a kinematic model of the structural assembly. The kinematic model may comprise a plurality of adjustable linkages of the structural assembly. The kinematic model may in particular involve a plurality of kinematic linkages the adjustment or positioning of which contributes to geometric effects on a plurality of measurement or observation points of the structural assembly. In a second method step M2, a kinematic influence matrix may be obtained. The kinematic influence matrix comprises information regarding the influence of each of the adjustable linkage positions of the plurality of adjustable linkages on the measurement value at each observation point of a plurality of predefined observation points. This kinematic influence matrix may for example be calculated once per structural assembly type as matrix INFL. The kinematic model as well as the kinematic influence matrix may for example be provided by a model provision unit and a matrix provision unit, respectively. Both units may for example be implemented in a modelling tool such as MECAmaster(R).

In a step M3, the actual position of each of the adjustable linkage positions of the plurality of adjustable linkages may be determined. It may for example be possible, for each adjustable linkage, to measure or otherwise obtain the actual position as a parameter vector ADJ. For example, a worksman may manually enter the actual positions into a calculation unit. The positions of the adjustable linkages may for example depend on a thickness of used shims, the position of a screw, the number of intermediate washers, the tightness of bolts or similar parameters. Each of the adjustable linkage positions may be subject to constraints such as a minimum and/or a maximum value which may be specific to each type of structural assembly.

In a further step M4, the values at each observation point of the plurality of predefined observation points may be measured. This may in particular be useful, if the plurality of linkages of the structural assembly further comprises a plurality of non-adjustable linkages. The kinematic influence matrix may in that case comprise information regarding the influence of each of the non-adjustable linkage positions of the plurality of non-adjustable linkages on the measurement value at each observation point of the plurality of predefined observation points. For each observation point, the actual gap, step or overlap is measured and put into a measurement value vector MEASURE, for example by an operator responsible for adjusting the structural assembly.

In another optional step M5, the actual position of each of the plurality of non-adjustable linkages may then be determined on the basis of the kinematic influence matrix INFL and the measurement value vector MEASURE at each observation point. This may for example be done by first selecting the respective system to which the structural assembly is adjusted, for example the type of airborne vehicle into which a door assembly is assembled. Then, the specific type of structural assembly is selected, thereby selecting the respective kinematic influence matrix INFL. The actual values of the parameter vector LINK is unknown, as well as the tolerance vector TOL. TOL is representing the tolerance between two or more observation points that may have the same influences and therefore should be at the same measured value if the tolerance would be zero. The following equation gives the link between all presented parameters:

$$INFL \times ADJ + INFL \times LINK + TOL = MEASURE$$

This equation can be simplified as INFL, LINK and TOL are constants, which yields

$$INFL \times ADJ + GAMMA = MEASURE$$

wherein

$$GAMMA = INFL \times LINK + TOL.$$

GAMMA may be determined, for example by substitution, elimination and/or summation or least squares algorithm, if observation points influences are linked.

At step M6, upper and/or lower thresholds (TARGET UP and TARGET LOW, respectively) are defined for each of the measurement values at each observation point of the plurality of predefined observation points. The thresholds may be defined as minimum and maximum allowed values for each measurement value and may be stored in the calculation unit. The thresholds may be defined specifically for each type of structural assembly.

At step M7, a linear least squares algorithm is executed to determine a tuple of linkage positions to which the plurality of adjustable linkages are to be adjusted. in order to get the measurement value at each observation point of a plurality of predefined observation points within the defined upper and/or lower thresholds. The system of equations determined at step M5 for each observation point is

$$GAMMA + INFL \times ADJ = MEASURE$$

In order to determine a rigging combination of adjustable positions ADJ for each of the adjustable linkages, a system of inequations for each measurement/observation point is determined as

$$\text{GAMMA} + (\text{INFL} \times \text{ADJ}) \leq \text{TARGET UP}$$

$$\text{GAMMA} + (\text{INFL} \times \text{ADJ}) \geq \text{TARGET LOW}$$

The unknown values in these inequations are the vector values of ADJ. The system of inequations is then solved with a linear least squares algorithm to obtain optimized values for the parameter vector ADJ. The algorithm is able to obtain the rigging combination that ensures that all measurement values are kept within the allowed range. If there is no solution, the algorithm may be able to propose to degrade a minimum of requirements (best-fit) regarding a prioritization of measurement values for the observation points. This may be performed by weighting at least one of the measurement values with a predefined weighting coefficient when executing the least squares algorithm.

With the least squares algorithm a tuple of linkage positions may be determined which takes into account a maximum allowed range of linkage positions for each or at least some of the plurality of adjustable linkages. Moreover, at least one of the adjustable linkage positions may be kept constant during the execution of the algorithm, in order to reduce the remaining rigging work for adjusting the structural assembly as much as possible. The least squares algorithm may be iteratively applied, in order to reach an optimum solution for the vector ADJ.

Fig. 2 schematically illustrates a system S for adjusting a structural assembly, in particular a door assembly. The system S may particularly be employed for adjusting a door assembly in an airborne vehicle.

The system comprises a model provision unit S1 which is configured to provide a kinematic model of the structural assembly, the kinematic model comprising a plurality of adjustable linkages of the structural assembly. A matrix provision unit S2 is configured to provide a kinematic influence matrix, the kinematic influence matrix comprising information regarding the influence of each of the adjustable linkage positions of the plurality of adjustable linkages on the measurement value at each observation point of a plurality of predefined observation points. Finally, the system S comprises a calculation unit S3 which is configured to integrate the current position of adjustable parameter and to define upper and/or lower thresholds for each of the measurement values at each observation point of the plurality of predefined observation points, and to apply a linear least squares algorithm to determine a tuple of linkage positions to which the plurality of adjustable linkages are to be adjusted in order to keep the measurement value at each observation point of a plurality of predefined observation points within the defined upper and/or lower thresholds.

When the plurality of linkages of the structural assembly further comprises a plurality of non-adjustable linkages, and the kinematic influence matrix comprises information regarding the influence of each of the non-adjustable linkage positions of the plurality of non-adjustable linkages on the measurement value at each observation point of the plurality of predefined observation points, the calculation unit S3 may further be configured to determine the actual position of each of the plurality of non-adjustable linkages on the basis of the kinematic influence matrix and measured values at each observation point of the plurality of predefined observation points. Additionally, the calculation unit S3 may further be configured to determine the actual position of each of the adjustable linkage positions of the plurality of adjustable linkages.

The calculation unit S3 may further be configured to determine the actual position of each of the adjustable linkage positions by measuring the actual position of each of the adjustable linkage positions, to determine a tuple of linkage positions taking into account the maximum allowed range of linkage positions for each of the plurality of adjustable linkages, to apply the linear least squares algorithm by weighting at least one of the measurement values with a predefined weighting coefficient, and/or to keep at least one of the adjustable linkage positions constant during the execution of the linear least-squares algorithm.

The use of the method and system of the invention will reduce the number of loops needed to find the right adjustment to reach all geometrical requirements during the installation of assemblies. This means a reduction of recurring cost, as this occurs on each adjustable assembly.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

EP 2 897 065 A1

List of reference numerals and signs

M   Method
M1  Method step
M2  Method step
M3  Method step
M4  Method step
M5  Method step
M6  Method step
M7  Method step
S   System
S1  Model provision unit
S2  Matrix provision unit
S3  Calculation unit

**Claims**

1.  Method (M) for adjusting a structural assembly, the method (M) comprising:

    obtaining (M1) a kinematic model of the structural assembly, the kinematic model comprising a plurality of adjustable linkages of the structural assembly;
    obtaining (M2) a kinematic influence matrix, the kinematic influence matrix comprising information regarding the influence of each of the adjustable linkage positions of the plurality of adjustable linkages on the measurement value at each observation point of a plurality of predefined observation points;
    defining (M6) upper and/or lower thresholds for each of the measurement values at each observation point of the plurality of predefined observation points; and
    applying (M7) a linear least squares algorithm to determine a tuple of linkage positions to which the plurality of adjustable linkages are to be adjusted in order to get the measurement value at each observation point of a plurality of predefined observation points within the defined upper and/or lower thresholds.

2.  Method (M) according to claim 1,
    measuring (M4) the values at each observation point of the plurality of predefined observation points.

3.  Method (M) according to claim 2, further comprising:

    getting (M3) the actual position of each of the adjustable linkage positions of the plurality of adjustable linkages.

4.  Method (M) according to claim 3, wherein getting (M3) the actual position of each of the adjustable linkage positions comprises measuring the actual position of each of the adjustable linkage positions.

5.  Method (M) according to one of the claims 1 to 4, wherein a tuple of linkage positions is determined taking into account the maximum allowed range of linkage positions for each of the plurality of adjustable linkages.

6.  Method (M) according to one of the claims 1 to 5, wherein applying (M7) the linear least squares algorithm includes weighting at least one of the measurement values with a predefined weighting coefficient.

7.  Method (M) according to one of the claims 1 to 6, wherein applying (M7) the linear least squares algorithm comprises keeping at least one of the adjustable linkage positions constant during the execution of the algorithm.

8.  System (S) for adjusting a structural assembly, the system (S) comprising:

    a model provision unit (S1) configured to provide a kinematic model of the structural assembly, the kinematic model comprising a plurality of adjustable linkages of the structural assembly;
    a matrix provision unit (S2) configured to provide a kinematic influence matrix, the kinematic influence matrix comprising information regarding the influence of each of the adjustable linkage positions of the plurality of adjustable linkages on the measurement value at each observation point of a plurality of predefined observation points; and

a calculation unit (S3) configured to get upper and/or lower thresholds for each of the measurement values at each observation point of the plurality of predefined observation points, and to apply a linear least squares algorithm to determine a tuple of linkage positions to which the plurality of adjustable linkages are to be adjusted in order to keep the measurement value at each observation point of a plurality of predefined observation points within the defined upper and/or lower thresholds.

9. System (S) according to claim 8, wherein the plurality of linkages of the structural assembly further comprises a plurality of non-adjustable linkages, and wherein the kinematic influence matrix comprises information regarding the influence of each of the non-adjustable linkage positions of the plurality of non-adjustable linkages on the measurement value at each observation point of the plurality of predefined observation points, and wherein the calculation unit (S3) is further configured to determine the actual position of each of the plurality of non-adjustable linkages on the basis of the kinematic influence matrix and measured values at each observation point of the plurality of predefined observation points.

10. System (S) according to claim 9, wherein the calculation unit (S3) is further configured to get the actual position of each of the adjustable linkage positions of the plurality of adjustable linkages.

11. System (S) according to claim 10, wherein the calculation unit (S3) is further configured to get the actual position of each of the adjustable linkage positions by measuring the actual position of each of the adjustable linkage positions.

12. System (S) according to one of the claims 8 to 11, wherein the calculation unit (S3) is further configured to determine a tuple of linkage positions taking into account the maximum allowed range of linkage positions for each of the plurality of adjustable linkages.

13. System (S) according to one of the claims 8 to 12, wherein the calculation unit (S3) is further configured to apply the linear least squares algorithm by weighting at least one of the measurement values with a predefined weighting coefficient.

14. System (S) according to one of the claims 8 to 13, wherein the calculation unit (S3) is further configured to keep at least one of the adjustable linkage positions constant during the execution of the linear least-squares algorithm.

15. Non-transitory computer-readable medium comprising computer-readable instructions which, when executed on a computer, cause the computer to perform a method according to one of the claims 1 to 7.

EP 2 897 065 A1

FIG. 1

FIG. 2

8

Europäisches Patentamt

European Patent Office

Office européen des brevets

## EUROPEAN SEARCH REPORT

Application Number

EP 14 15 1741

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Paul Clozel ET AL: "MECAmaster: a Tool for Assembly Simulation from Early Design, Industrial Approach" In: "Geometric Tolerancing of Products", May 2010 (2010-05), Wiley-ISTE, XP055120067, ISBN: 978-1-84-821118-6 pages 241-273, * the whole document * | 1-15 | INV. G06F17/50 |
| Y | JINSONG GAO ET AL: "Generalized 3-D tolerance analysis of mechanical assemblies with small kinematic adjustments", IIE TRANSACTIONS, INSTITUTE OF INDUSTRIAL ENGINEERS, NORCROSS, GA, US, vol. 30, no. 4, 1998, pages 367-377, XP008169609, ISSN: 0740-817X, DOI: 10.1023/A:1007451225222 * page 373, right column, last paragraph above equation (16) * | 1-15 | |

TECHNICAL FIELDS SEARCHED (IPC)

G06F

The present search report has been drawn up for all claims

| Place of search | Date of completion of the search | Examiner |
|---|---|---|
| Munich | 4 June 2014 | Picallo Gonzalez, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 897 065 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6243614 B1
- CN 103061641 A
- DE 19530725 A1